(19) Europäisches Patentamt

European Patent Office

Office européen des brevets

(11) **EP 0 493 125 B1**

(12) **EUROPEAN PATENT SPECIFICATION**

(45) Date of publication and mention
of the grant of the patent:
**27.05.1998 Bulletin 1998/22**

(51) Int Cl.6: **H01S 3/19**, H01L 33/00

(21) Application number: **91312048.1**

(22) Date of filing: **27.12.1991**

(54) **Semiconductor laser device**

Halbleiterlaser

Laser à semi-conducteur

(84) Designated Contracting States:
**DE FR GB NL**

(30) Priority: **27.12.1990 JP 417845/90**

(43) Date of publication of application:
**01.07.1992 Bulletin 1992/27**

(73) Proprietor: **THE FURUKAWA ELECTRIC CO., LTD.
Tokyo 100 (JP)**

(72) Inventors:
- **Irikawa, Michinori,
  THE FURUKAWA ELECTRIC CO., LTD
  Chiyoda-ku, Tokyo 100 (JP)**
- **Iwase, Masayuki,
  THE FURUKAWA ELECTRIC CO. LTD.,
  Chiyoda-ku, Tokyo 100 (JP)**

(74) Representative: **Gibson, Stewart Harry et al
URQUHART-DYKES & LORD,
Three Trinity Court,
21-27 Newport Road
Cardiff CF2 1AA (GB)**

(56) References cited:
**DE-A- 3 717 535     JP-A- 1 201 980**

- **PATENT ABSTRACTS OF JAPAN vol. 6, no. 155 (E-125)(1033) 17 August 1982 & JP-A-57 075 483 ( NIPPON DENKI K.K. )**
- **PATENT ABSTRACTS OF JAPAN vol. 10, no. 50 (E-384)(2107) 27 February 1986 & JP-A-60 202 978 ( TOSHIBA K.K. )**
- **PATENT ABSTRACTS OF JAPAN vol. 5, no. 30 (E-47) 24 February 1981 & JP-A-55 158 689 ( SUMITOMO ELECTRIC IND. LTD. )**
- **PATENT ABSTRACTS OF JAPAN vol. 6, no. 238 (E-144)(1116) 26 November 1982 & JP-A-57 139 986 ( SANYO DENKI K.K. )**
- **PATENT ABSTRACTS OF JAPAN vol. 13, no. 218 (E-761) 22 May 1989 & JP-A-1 030 287 ( MATSUSHITA ELECTRIC IND. CO. LTD. )**
- **PATENT ABSTRACTS OF JAPAN vol. 11, no. 363 (E-560) 26 November 1987 & JP-A-62 137 881 ( FUJITSU LTD. )**
- **PATENT ABSTRACTS OF JAPAN vol. 13, no. 453 (E-831) 11 October 1989 & JP-A-1 175 727 ( NEC CORP. )**
- **JOURNAL OF APPLIED PHYSICS. vol. 63, no. 3, 1 February 1988, NEW YORK US pages 964 - 966; F. SATO ET AL.: 'Low thermal expansion polymide buried ridge waveguide AlGaAs/GaAs single-quantum-well laser diode'**
- **APPLIED PHYSICS LETTERS. vol. 41, no. 10, November 1982, NEW YORK US pages 903 - 905; H. BLAUVELT ET AL.: 'Narrow stripe AlGaAs lasers using double current confinement'**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

# Description

## BACKGROUND OF THE INVENTION

[Technical Field]

This invention relates to a ridged waveguide-type semiconductor laser device having a reduced threshold current level as well as other improved and useful properties.

[Background Art]

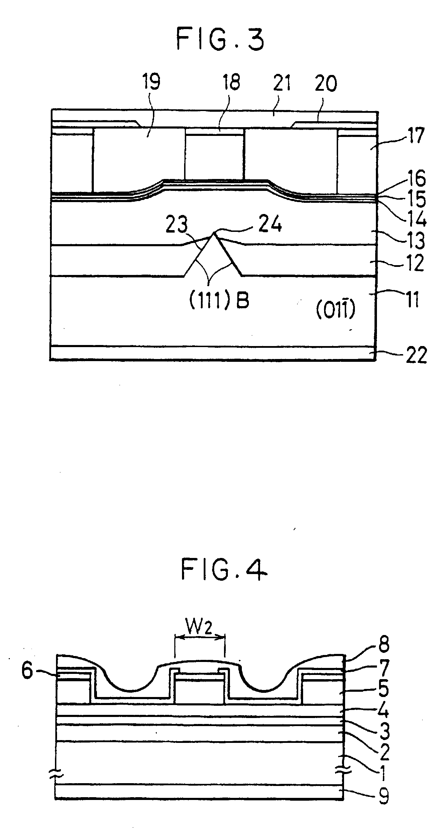

A known ridged waveguide-type semiconductor laser devices typically has a structure as illustrated in Fig. 4 and is produced through a manufacturing process as described below.

Firstly, an n-InP clad layer 2, an active layer 3, an antimeltback layer 4, a p-InP clad layer 5, a p-GaInAsP cap layer 6 are sequentially grown in the described order on an n-InP substrate 1 to form a multilayered structure and then a SiO$_2$ insulation layer is deposited on the top.

Then, an etching mask is prepared by using a photolithography technique to cover specific areas of the multilayered structure and the covered multilayered structure is etched as deep as the antimeltback layer 4 to produce a pair of grooves cut into said multilayered structure.

After removing the etching mask, an insulation layer 7 is formed thereon and again a photolithography technique is used to cut a window for ohmic contact of a p-side electrode.

Finally, a p-side electrode 8 and an n-side electrode 9 are formed respectively on the upper surface of the multilayered structure and the lower surface of the substrate 1.

Since a semiconductor laser device as described above shows different diffractive indexes relative to the active layer at the ridge portion located at the center of the upper surface and at the lateral grooves on the sides of the ridge portion, it is normally provided with a waveguide designed on the basis of the difference of refractive index. Therefore, such a semiconductor laser device is normally called a ridged waveguide-type semiconductor laser device.

Since a ridged waveguide-type semiconductor laser device can be manufactured by way of a single epitaxial growth process, it is advantageous over semiconductor laser devices having a different structure in terms of yield, cost and mass production.

A ridged waveguide-type semiconductor laser device having the following characteristics is reported in Paper 1 listed below: threshold current level Ith = 25 ~ 30mA, optical output Pmax = 30mW, quantum efficiency $\eta o = 20 \sim 25\%$ (oscillation wavelength a = 1.3$\mu$m), angle of horizontal beams relative to the substrate $\theta\| = 16°$ and angle of vertical beams relative to the substrate $\theta\bot = 30°$.

Paper 1: A.M. Rashid, IEEE J. Lightwave Tech. Vol. 6, pp.25-29, 1988

A known ridged waveguide-type semiconductor laser device is, however, accompanied by technological problems as listed below.

(1) It has a low current confinement effect and a high threshold current level.
(2) Due to the beam angles of $\theta\bot = 30°$ and $\theta\| = 16°$, it shows a large $\theta\bot/\theta\|$ ratio.
(3) Since a window should be formed for ohmic contact within the ridged portion, the ridge stripe width cannot be made narrow.
(4) It shows poor thermal characteristics because of its poor heat conduction capability.

A resin embedded ridge waveguide semiconductor laser according to the preamble of claim 1 is known from J, Appl. Phys. 63(1988) 964.

## SUMMARY OF THE INVENTION

In view of these technological problems, it is therefore an object of the present invention to provide a semiconductor laser device having a low threshold current level, a small $\theta\bot/\theta\|$ ratio, a narrow ridge stripe width and improved thermal characteristics.

According to the present invention as defined in claim 1. The above object there is provided a semiconductor laser diode of the ridged waveguide type, comprising a substrate of a first conductivity type, a heterostructure disposed on said substrate and including an active layer disposed between clad layers of first and second conductivity types respectively, and a ridged waveguide structure formed of etched-off parts of the clad layer of second conductivity type and directly embedded with resin material, characterised in that said substrate comprises InP and a current confining structure is formed between said substrate and said clad layer of first conductivity type, said current confining structure comprising an InP convex mesa stripe of the first conductivity type disposed on said substrate and an InP current blocking layer of a second conductivity type disposed at both sides of said mesa stripe.

A method of fabricating such a laser device is defined in claim 7.

The active layer may comprise a DCC (double carrier confinement) structure having two separate layers and an intermediate clad layer interposed therebetween, and/or it may comprise either a single quantum well structure or a multi-quantum well structure preferably with an optical confinement layer having either an SCH structure or a GRIN-SCH structure.

Since a semiconductor layer device according to the invention further comprises a current confinement structure formed between the semiconductor substrate and the active layer, injected current is confined not only at the ridge side but also at the substrate side of the active layer to improve the current confinement effect of the device.

The current blocking layer may comprise an Fe-doped InP semi-insulating layer. When the substrate of the semiconductor layer device comprises p-InP, the current blocking layer preferably comprises an Fe-doped InP semi-insulating layer sandwiched between upper and lower n-InP layers. Therefore the p-InP substrate and the Fe-doped InP layer are not in direct contact with each other, so that the semi-insulating property of the Fe-doped InP layer is not deteriorated.

The current confinement structure may comprise a mesa stripe having a pair of symmetrical surfaces (111) B to show as an isosceles triangle in cross section if cut through a cleavage surface (011) or (011) and projecting into the clad layer of the first conductivity type to form a narrow injection channel. In this case, the double heterostructure can be grown continuously after forming the mesa stripe of isosceles triangle cross section and the narrow channel for confining injected current can be formed simultaneously.

Because the two parts either side of the ridge stripe of the semiconductor laser device are embedded with resin, the window for ohmic contact need not be limited within the width of the ridge. With such an arrangement therefore, a patterning operation can be conducted without difficulty in the process of photolithography and the ridge stripe width can be reduced to an optimum value from the view point of ohmic resistance and lasing threshold current.

The heat conductance capability of the device is remarkably improved when the resin comprises a polyimide resin.

When the semiconductor substrate of the semiconductor laser device according to the invention is p-type, the ridge and the cap layer (e.g.: GaInAsP) are of n-type.

It is a well-known fact that an InP substrate of p-type has a specific resistance greater than that of an InP substrate of n-type and that a GaInAsP cap layer of n-type has a resistivity lower than that of a GaInAsP cap layer of p-type.

Therefore, when the semiconductor substrate is made of p-InP and the ridge and the cap layer are made of n-GaInAsP, the ridge stripe width and the threshold current may be further reduced because of a very low ohmic resistance.

When the active layer of a semiconductor laser device according to the invention is made of a DCC (double carrier confinement) structure having two separate layers and an intermediate clad layer interposed therebetween, $\theta\perp$ can be made as small as 20°.

Consequently, the $\theta\perp/\theta\parallel$ ratio can be remarkably improved to as small as 1.3 from the current level (1.9) so that the coupling efficiency of the laser beam from the semiconductor laser device to an optical fiber is improved. As a further advantage, the DCC structure also shows excellent temperature stability.

Improvements on temperature characteristics of semiconductor laser devices with DCC structure are reported in paper 2 listed below.

Paper 2: M. Yano, et al, Journal Quantum Electron 19, pp. 1319-13279, 1983.

A semiconductor laser device according to the invention can be manufactured by means of a known appropriate method such as a liquid-phase epitaxial method (LPE method) or a vapour phase epitaxial method (e.g.: MOCVD method).

Now, the present invention will be described in greater detail by referring to the accompanying drawings that illustrate preferred embodiments of the invention.

BRIEF DESCRIPTION OF THE DRAWINGS

Fig. 1 is a sectional view of a first embodiment of the semiconductor laser device according to the invention.

Fig. 2 is a sectional view of a second embodiment of the semiconductor laser device according to the invention.

Fig. 3 is a sectional view of a third embodiment of the semiconductor laser device according to the invention.

Fig. 4 is a sectional view of a conventional semiconductor laser device.

DETAILED DESCRIPTION OF THE INVENTION

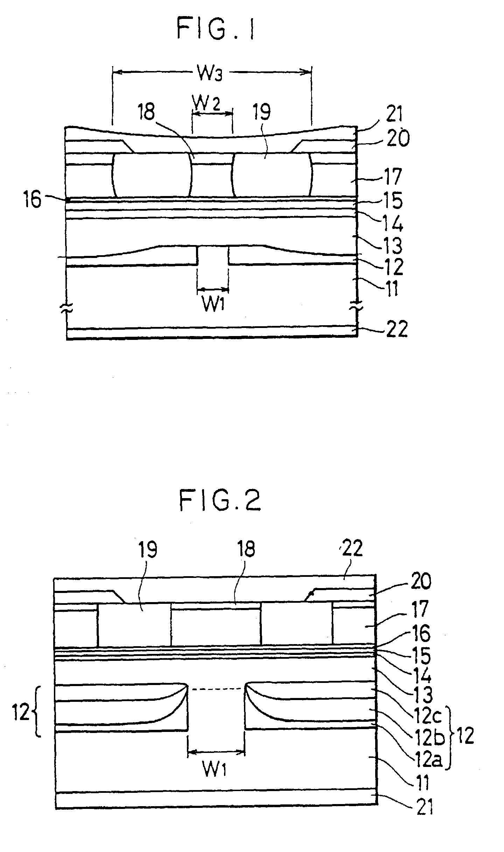

Now the present invention will be described by referring to Fig. 1 illustrating a first preferred embodiment of the invention.

In Fig. 1, an p-InP current blocking layer 12, an n-InP clad layer 13, a GaInAsP active layer 14, a p-InP clad layer 15, a p-GaInAsP etching stop layer 16, a p-InP clad layer 17, a p-GaInAsP cap layer 18, resin layers 19 made of polyimide resin and an insulation film layer 20 made of a dielectric material are sequentially formed in the described order on an n-InP substrate 11 to form a multilayered structure. Besides, a p-side electrode 21 is disposed on the upper surface of the multilayered structure, while an n-side electrode 22 is arranged on the lower surface of the n-InP substrate 11.

A semiconductor laser device as illustrated in Fig. 1 may be prepared through a manufacturing process as described below.

Firstly, a piece of insulation film (not shown) made of $SiO_2$ or $Si_3N_4$ is deposited on an n-InP substrate 11 and then a stripe-shaped etching mask is formed by using a photolithography technique. Then, unnecessary areas of the insulation film are removed by dry or wet etching so that a stripe-shaped ridge is formed by the remaining insulation film.

Referring to Fig. 1, the stripe-shaped ridge has a width of 0.5 to 1μm and a height of 0.5 to 2μm.

Then, a current blocking layer 12 is formed on the n-InP substrate 11 by growing a p-InP layer under the masked condition of the substrate.

A liquid-phase epitaxial method (LPE method) or a vapor phase epitaxial method (MOCVD method) is used for the growth of the p-InP current blocking layer 12.

Subsequently, the mask is removed by etching and then an n-InP clad layer 13, a GaInAsP active layer 14, a p-InP clad layer 15, a p-GaInAsP etching stop layer 16, a p-InP clad layer 17 and a p-GaInAsP cap layer 18 are sequentially formed on the n-InP substrate 11 to produce a multilayered structure by the one-step growth.

Thereafter, given areas are masked (by an etching mask similar to the one as described earlier) by using a photolithography technique and then the masked structure is etched to as deep as the etching stop layer 16 so that a pair of substantially parallel grooves are formed on the n-InP substrate 11 to produce a ridge having a width W2 as illustrated in Fig. 2.

Then, the two grooves are filled with polyimide resin to form resin layers in these areas.

Since any excessive resin of the resin layers 19 is removed by etching to make the surface of the resin layers found on the level of the surface of the cap layer 18, the upper surface of the n-InP substrate 11 becomes very flat at this stage.

Thereafter, insulation film of $SiO_2$ or $Si_3N_4$ is deposited on the n-InP substrate 11 and a contact window is formed by using a photolithography technique as described earlier.

The position of the window area does not have to be limited within ridge area so long as it has a width smaller than the distance W3 between the outer boundaries of the two grooves.

Then, a p-side electrode is formed on the upper surface of the multilayered structure on the n-InP substrate 11, while a n-side electrode 22 is formed on the lower surface of the n-InP substrate 11 by using a known technique.

A semiconductor laser device produced through a manufacturing process as described above has a current confinement structure that enables electric current to be confined because of a p-InP current blocking layer 12 sandwiched by an n-InP substrate 11 and an n-InP clad layer 13 and pn reverse junction existent between a p-InP current blocking layer 12 and an n-InP clad layer 13.

With such a configuration, the resin layers 19 effectively eliminate the necessity of confining the window of insulating layer 20 for ohmic contact between the p-GaInAsP cap layer 18 and the p-side electrode 21 within an area of the ridge.

This means that the ridge stripe width can be reduced to consequently lower the lasing threshold current level as compared with that of a conventional semiconductor laser device.

It may be appropriate to note here that polyimide resin has a refractive index of 1.8 and a thermal expansion coefficient which is substantially equal to 4.5 x $10^{-6}K^{-1}$ or the thermal expansion coefficient of InP.

When the resin layers are made of polyimide resin, the semiconductor laser device is free from problems concerning the waveguide structure and thermal stress.

If junction down bonding is conducted for a semiconductor laser device according to the invention, taking advantage of the fact that the grooves for resin layers are filled with poiyimide resin, the heat conductance capability of the device will be further improved.

While a p-InP clad layer 15 is formed on a GaInAsP active layer 14 and a p-GaInAsP etching stop layer 16 is formed on the p-InP clad layer 15 in the above embodiment, those two layers may be replaced by a single antimeltback layer formed directly on the active layer 14.

The use of an active layer 14 having a DCC structure in place of the single layer bulk may further improve the various characteristics of the embodiment.

Now, a second embodiment of the invention will be described below by referring to Fig. 2.

The substrate 11 of the embodiment of Fig. 2 is made of p-InP and the current blocking layer 12 has in fact a multilayered structure comprising a Fe doped semi-insulating layer 12b sandwiched by upper and lower n-InP layers 12a and 12c.

The remaining parts of the embodiment are identical with or similar to the corresponding ones of the first embodiment as described earlier by referring to Fig. 1.

It is a well known fact that when a Fe-doped semi-insulating layer is brought to contact with a p-InP layer in growth step, the semi-insulating property of the Fe-doped semiinsulating layer is deteriorated.

With a semiconductor laser device as illustrated in Fig. 2, since the Fe doped InP layer 12b is sandwiched the two p-InP layers to prevent such direct contact as described above, the semiinsulating property of the current blocking layer 12 is not deteriorated and the functions of the layer are fully preserved.

Finally, a third preferred embodiment of the invention will be described by referring to Fig. 3.

In a semiconductor laser device as illustrated in Fig. 3, a stripe (23) having a pair of symmetrical lateral surfaces (111) B to show as isosceles triangle in cross section is formed to contact the upper surface of an n-InP substrate 11 and partly occupy the lower portion of an n-InP clad layer 13 sandwiched with a p-InP current blocking layer 12 held therebetween and the top 24 of the stripe projects into a bottom area of the clad layer 13 as may be understood by referring to the cleavage surface (01$\bar{1}$) of Fig. 3.

The above description holds true with regard to the cleavage surface (011) not shown in Fig. 3.

The remaining parts of the embodiment are identical with or similar to the corresponding ones of the first and second embodiments as described earlier by referring to Figs. 1 and 2.

For a semiconductor laser device as illustrated in Fig. 3, a stripe 23 running in the direction of $<01\bar{1}>$ can be formed by wet etching with mask and thereafter a p-InP current blocking layer 12 and an n-InP clad layer 13 as well as all other layers up to layer 18 can be made to grow thereon continuously to produce narrow n-InP channels 24.

Some techniques for the above described method are presented in Papers 3 and 4 listed below.

Paper 3: A. Yoshikawa, et al., Journal of Crystal Growth 93, pp.843-849, 1988

Paper 4: K.M. Dzurko, et al., Appl. Phys. Lett. 54, pp. 105-107, 1989

The active layer 14 of each of the above described embodiments may have either a simple quantum well structure or a multiple quantum well structure and comprise an optical confinement layer having either an SCH structure or a GRIN-SCH structure.

Since a semiconductor laser device according to any of the claims has a low threshold current level, a small $\theta_{\parallel}/\theta_{\perp}$ ratio, a narrow ridge stripe width and improved thermal characteristics, the present invention provides a useful and effective semiconductor laser device.

## Claims

1. A semiconductor laser diode of the ridged waveguide type, comprising a substrate (11) of a first conductivity type, a heterostructure disposed on said substrate (11) and including an active layer (14) disposed between clad layers (13,17) of first and second conductivity types respectively, and a ridged waveguide structure formed of etched-off parts of the clad layer (17) of second conductivity type and directly embedded with resin material (19), characterised in that said substrate (11) comprises InP and a current confining structure is formed between said substrate (11) and said clad layer (13) of first conductivity type, said current confining structure comprising an InP convex mesa stripe (W1, 23) of the first conductivity type disposed on said substrate (11) and an InP current blocking layer (12) of a second conductivity type disposed at both sides of said mesa stripe (W1, 23).

2. A semiconductor laser diode as claimed in claim 1, characterised in that said current blocking layer comprises an Fe-doped InP semi-insulating layer (12b).

3. A semiconductor laser diode as claimed in claim 1, characterised in that said substrate (11) is a p-InP substrate and said current blocking layer comprises said Fe-doped InP semi-insulating layer (12b) disposed between first and second n-InP layers (12a, 12c).

4. A semiconductor laser diode as claimed in any preceding claim, characterised in that said substrate (11) is oriented on the (100)-plane and said mesa stripe (23) has the shape of an isosceles triangle in cross-section and having a pair of symmetrical surfaces (111)B, the top (24) of the mesa stripe projecting into said clad layer (13) of the first conductivity type, to form a current injection channel.

5. A semiconductor laser diode as claimed in any preceding claim, characterised in that said active layer (14) comprises a single quantum well structure or a multi-quantum well structure.

6. A semiconductor laser diode as claimed in any preceding claim, characterised in that said active layer comprises a double carrier confinement (DCC) structure having an intermediate clad layer.

7. A method of fabricating a semiconductor laser diode of the ridged waveguide type, comprising forming a heterostructure on a substrate (11), said heterostructure including an active layer (14) disposed between clad layers (13,17) of first and second conductivity type respectively, etching off parts of the clad layer (17) of second conductivity type to form a ridged waveguide structure, and directly embedding said etched off parts with resin material (19), characterised in that said substrate comprises InP and a current confining structure is formed between said substrate (11) and said clad layer (13) of first conductivity type by etching off parts of said substrate (11) to form an InP convex mesa stripe (W1, 23) on said substrate (11) and then forming an InP current blocking layer (12) of a second conductivity type at both sides of said mesa stripe (W1, 23) by a liquid-phase growth method or by a vapour phase growth method.

## Patentansprüche

1. Halbleiterlaserdiode vom grat- oder stegförmigen Wellenleitertyp, die ein Substrat (11) eines ersten Leitfähigkeitstyps, eine Heterostruktur, die auf dem Substrat (11) angeordnet ist und eine aktive Schicht (14), die zwischen Mantelschichten (13,17) vom ersten und zweiten Leitfähigkeitstyp angeordnet ist, und eine grat- oder stegförmige Wellenleiterstruktur aufweist, die aus weggeätzten Teilen der Mantelschicht (17) vom zweiten Leitfähigkeitstyp gebildet ist und indirekt mit Harzmaterial (19) eingebracht ist, dadurch gekennzeichnet, daß das Substrat (11) InP aufweist und eine Strombegrenzungsstruktur zwischen dem Substrat (11) und der Mantelschicht (13) vom ersten Leitfähigkeitstyp gebildet ist, wobei die Strombegrenzungsstruktur einen konvexen Mesastreifen (W1, 23) aus InP vom ersten Leitfähigkeitstyp der auf dem Substrat (11) angeordnet ist, und eine InP-Stromsperrschicht (12) eines zweiten Leitfähigkeitstyps aufweist, der auf beiden Seiten des Mesastreifens (W1, 23) angeordnet ist.

2. Halbleiterlaserdiode nach Anspruch 1, dadurch gekennzeichnet, daß die Stromsperrschicht eine Fe-dotierte halbsolierende InP-Schicht (12b) aufweist.

3. Halbleiterlaserdiode nach Anspruch 1, dadurch gekennzeichnet, daß das Substrat (11) ein p-InP-Substrat ist und die Stromsperrschicht die Fe-dotierte halbisolierende InP-Schicht (12b), die zwischen den ersten und zweiten n-Inp-Schichten (12a, 12c) angeordnet ist, aufweist.

4. Halbleiterlaserdiode nach einem vorangehenden Anspruch, dadurch gekennzeichnet, daß das Substrat (11) auf der (100)-Ebene orientiert ist und der Mesastreifen (23) die Form eines gleichschenkligen Dreiecks im Querschnitt hat und ein Paar von symetrischen Oberflächen (111)B aufweist, wobei die Oberseite (24) des Mesastreifens in die Mantelschicht (13) des ersten Leitfähigkeitstyps hineinragt, um einen Strominjektionskanal zu bilden.

5. Halbleiterlaserdiode nach einem vorangehenden Anspruch, dadurch gekennzeichnet, daß die aktive Schicht (14) eine Einzelquantenmuldenstruktur oder eine Vielquantenmuldenstruktur einschließt.

6. Halbleiterlaserdiode nach einem vorangehenden Anspruch, dadurch gekennzeichnet, daß die aktive Schicht eine doppelte Trägereingrenzungs (DCC)-Struktur aufweist, die eine dazwischenliegende Mantelschicht aufweist.

7. Verfahren zum Erstellen einer Halbleiterlaserdiode vom Grat- oder Stegwellenleitertyp, das aufweist, eine Heterostruktur auf einem Substrat (11) auszubilden, welche Heterostruktur eine aktive Schicht (14) aufweist, die zwischen Mantelschichten (13,17) vom ersten und zweiten Leitfähigkeitstyp angeordnet ist, Teile der Mantelschicht (17) des zweiten Leitfähigkeitstyps wegzuätzen, um eine grat- oder stegförmige Wellenleiterstruktur zu bilden, und direkt in die weggeätzten Teile Harzmaterial (19) einzubringen, dadurch gekennzeichnet, daß das Substrat InP aufweist und eine Strombegrenzungsstruktur zwischen dem Substrat (11) und der Mantelschicht (13) des ersten Leitfähigkeitstyps durch Wegätzen von Teilen des Stubtrats (11) gebildet wird, um einen konvexen Mesastreifen (W1, 23) aus InP auf dem Substrat (11) zu bilden und dann eine InP-Stromsperrschicht (12) des zweiten Leitfähigkeitstyps auf beiden Seiten des Mesastreifens (W1, 23) durch ein Flüssigphasenwachsverfahren oder durch ein Dampfphasenwachsverfahren zu bilden.

## Revendications

1. Diode laser à semi-conducteur du type à guide d'ondes à moulures, comprenant un substrat (11) d'un premier type de conductivité, une hétérostructure disposée sur ledit substrat (11) et comprenant une couche (14) active disposée entre des couches (13, 17) plaquées d'un premier et second types de conductivité respectivement, et une structure à guide d'ondes à moulures formée de parties décapées de la couche (17) plaquée d'un second type de conductivité et directement intégrée à l'aide de matériau (19) résineux,

    caractérisée en ce que ledit substrat (11) comprend du InP et une structure enfermant le courant est formée entre ledit substrat (11) et ladite couche (13) plaquée du premier type de conductivité, ladite structure enfermant le courant comprenant une bande (W1, 23) mesa convexe de InP, du premier type de conductivité, disposée sur ledit substrat (11) et une couche (12) de InP bloquant le courant, d'un second type de conductivité, disposée sur les deux faces de ladite bande (W1, 23) mesa.

2. Diode laser à semi-conducteur selon la revendication 1, caractérisée en ce que ladite couche bloquant le courant comprend une couche (12b) semi-isolante de Inp dopée en Fe.

3. Diode laser à semi-conducteur selon la revendication 1, caractérisée en ce que ledit substrat (11) est un substrat p-InP et ladite couche bloquant le courant comprend ladite couche (12b) semi-isolante de InP dopée en Fe disposée entre une première et deuxième couches (12a, 12c) de n-InP.

4. Diode laser à semi-conducteur selon l'une quelconque des revendications précédentes, caractérisée en ce que ledit substrat (11) est orienté sur le plan (100) et ladite bande (23) mesa présente la forme d'un triangle isocèle selon une coupe transversale et comportant une paire de surfaces symétriques (111)B, le sommet (24) de la bande mesa faisant saillie dans ladite couche (13) plaquée du premier type de conductivité, de façon à former un canal d'injection de courant.

5. Diode laser à semi-conducteur selon l'une quelconque des revendications précédentes, caractérisée en ce que ladite couche (14) active comprend une unique structure de puits quantique ou une structure de puits multi-quantique.

**6.** Diode laser à semi-conducteur selon l'une quelconque des revendications précédentes, caractérisée en ce que ladite couche active comprend une structure de confinement de support double comportant une couche plaquée intermédiaire.

**7.** Procédé de fabrication d'une diode laser semi-conducteur du type à guide d'ondes à moulures, comprenant une formation d'une hétérostructure sur un substrat (11), ladite hétérostructure comprenant une couche (14) active disposée entre des couches (13, 17) plaquées d'un premier et second types de conductivité respectivement, décapant des parties de ladite couche (17) plaquée du second type de conductivité, de façon à former une structure de guide d'ondes à moulures, et intégrant directement lesdites parties décapées à l'aide de matériau (19) résineux,

caractérisé en ce que ledit substrat comprend du InP et une structure enfermant le courant est formée entre ledit substrat (11) et ladite couche (13) plaquée du premier type de conductivité en décapant des parties dudit substrat (11), de façon à former une bande (W1, 23) mesa convexe de InP sur ledit substrat (11) et formant ensuite une couche (12) de InP bloquant le courant d'un second type de conductivité au niveau des deux faces de ladite bande (W1, 23) mesa par un procédé d'expansion en phase liquide ou par un procédé d'expansion en phase vapeur.

# FIG. 1

# FIG. 2

# FIG.3

# FIG.4